# EUROPEAN PATENT APPLICATION

(11) **EP 2 701 205 A1**
(43) Date of publication of application: **26.02.2014**
(21) Application number: 13168880.6
(22) Date of filing: 23.05.2013
(51) Int. Cl.: H01L 31/0352, H01L 31/18, H01L 33/00, H01L 33/06, H01L 33/50, H01L 27/146, H01L 29/06, B82Y 10/00, B82Y 40/00

(54) **Method of manufacturing quantum dot device, quantum dot device manufactured by using the method, and method of measuring electron mobility of quantum dot device**

(30) Priority: 21.08.2012 KR 20120091475
(71) Applicant: Samsung Electronics Co., Ltd, Gyeonggi-do 443-742 (KR)
(72) Inventor: Chung, Dae-young, 449-712 Gyeonggi-do (KR); Cho, Kyung-sang, 449-712 Gyeonggi-do (KR); Kim, Tae-ho, 449-712 Gyeonggi-do (KR); Choi, Byoung-lyong, 449-712 Gyeonggi-do (KR)
(74) Representative: Zijlstra, Robert Wiebo Johan

(57) **Abstract**

A method of manufacturing a quantum dot (QD) device (200) includes: forming a first QD solution (221a) obtained by dispersing a plurality of QDs in a mixture of a solvent and an anti-solvent; and forming a first QD layer (231) on a substrate structure by applying the first QD solution onto the substrate structure and naturally evaporating the first QD solution. Consequent quantum dot layers may be formed laterally spaced from (Fig. 5) or stacked onto (Fig. 6) the first layer

## Description

### BACKGROUND OF THE INVENTION

The present disclosure relates to methods of manufacturing quantum dot (QD) devices, QD devices manufactured using the methods, and methods of measuring the electron mobilities of QD devices.

Interest in various electronic devices incorporating quantum dots (QDs) has recently increased.

A QD is a nanocrystal of a semiconductor material that has a diameter equal to or less than about 10 nm and that exhibits a quantum confinement effect. Although a QD includes hundreds of thousands of electrons, because most of the electrons are tightly bound to an atomic nucleus, the number of free electrons which are not bound to the atomic nucleus is limited to about 1 to about 100. Because the energy levels of the electrons are discontinuously limited, the QD shows electrical and optical properties different from those of a bulk semiconductor which forms a continuous band. Because energy levels of a QD vary according to its size, the bandgap may be adjusted by simply changing the size of the QD. For example, when a QD is applied to a light-emitting device, the wavelength of light emitted by the light-emitting device may be adjusted by changing the size of the QD.

Such a QD may be applied to various devices, such as light-emitting devices, solar cells, transistors, and display devices.

In order to form a QD layer including QDs, a liquid-phase process comprising forming a solution in which the QDs are dispersed and then spin-coating the solution is often used. However, it is very difficult to adjust the thicknesses of QDs due to the relatively low solubility of QDs in an organic solvent, and more than half of the QDs are discarded during the spin-coating. As a result, there is a demand for a method which may solve these problems.

### SUMMARY OF THE INVENTION

The invention provides methods of manufacturing QD devices, QD devices manufactured by using the methods, and methods of measuring the electron mobilities of QD devices.

According to a first aspect of the invention, there is provided a method of manufacturing a quantum dot (QD) device including: forming a first QD solution obtained by dispersing a plurality of QDs in a mixture of a solvent and an anti-solvent; and forming a first QD layer on a substrate structure by applying the first QD solution onto the substrate structure and naturally evaporating the first QD solution.

The plurality of QDs may include inorganic QDs which may have inorganic ligands formed on surfaces thereof. The solvent may include at least one of dimethyl sulfoxide (DMSO), water, formamide, and ethanolamine. The anti-solvent may include at least one of dimethylformamide (DMF), ethylene glycol, acetonitrile, and glycerin.

The plurality of QDs may include organic QDs which may have organic ligands formed on surfaces thereof. The solvent may include at least one of cyclohexane, chloroform, toluene, p-xylene, chlorobenzene, and dichlorobenzene. The anti-solvent may include tetrahydrofuran (THF).

The substrate structure may include a transparent substrate. Transparent barriers for dividing a region on the transparent substrate into plurality of regions may be further formed on the transparent substrate.

The method may further include: forming a second quantum solution by dispersing a plurality of QDs having sizes or materials different from those of the QDs included in the first QD solution in a mixture of a solvent and an anti-solvent; and forming a second QD layer on the transparent substrate by applying the second QD solution on a portion of the transparent substrate where the first QD layer is not formed and naturally evaporating the second QD solution.

The substrate structure may include a light-emitting structure that emits light having a predetermined wavelength.

The forming of the first QD solution may include forming the first QD solution by using a plurality of QDs that absorb light emitted by the light-emitting structure and emit light having a wavelength longer than that of the light emitted by the light-emitting structure.

The method may further include: forming a second QD solution by dispersing a plurality of QDs having sizes or materials different from those of the QDs included in the first QD solution in a mixture of a solvent and an anti-solvent; and forming a second QD layer on the first QD layer by applying the second QD solution onto the first QD layer and naturally evaporating the second QD solution.

The substrate structure may include a substrate and a first electrode layer that is formed on the substrate. The method may further include forming a second electrode layer on the first QD layer and/or second QD layer.

According to another aspect of the invention, there is provided a method of measuring an electron mobility of a QD device which includes: forming a QD solution by dispersing a plurality of QDs in a mixture of a solvent and an anti-solvent; forming a QD layer on a first electrode layer by applying the first QD solution onto the first electrode layer and naturally evaporating the first QD solution; forming a second electrode layer on the QD layer; irradiating light to the QD layer in a direction from the first electrode layer toward the second electrode layer; and measuring a time taken for electrons excited by the light to pass through the QD layer.

The light may be laser light having energy greater than a work function of a material forming the first electrode layer.

A thickness of the QD layer may be equal to or greater than about 0.5 µm.

According to another aspect of the invention, there is provided a QD device including: a substrate structure; and a first QD layer that is formed on the substrate structure, includes a plurality of inorganic QDs, and has a thickness equal to or greater than about 50 nm.

The substrate structure may include a transparent substrate. The QD device may further include barriers that are formed on the transparent substrate to divide a region of the transparent substrate into a plurality of regions. The barriers may be transparent.

The QD device may further include a second QD layer that is formed on a portion of the transparent substrate where the first QD layer is not formed, which includes a plurality of inorganic QDs having sizes or materials different from those of the QDs constituting the first QD layer, and has a thickness equal to or greater than about 50 nm.

The substrate structure may include a light-emitting structure that emits light having a predetermined wavelength. The plurality of inorganic QDs constituting the first QD layer may absorb light emitted by the light-emitting structure and emit light having a wavelength longer than that of the light emitted by the light-emitting structure. The QD device may further include a second QD layer that is formed on the first QD layer, which includes a plurality of inorganic QDs having sizes or materials different from those of the plurality of inorganic QDs constituting the first QD layer, and has a thickness equal to or greater than about 50 nm.

The substrate structure may include a substrate and a first electrode layer that is formed on the substrate, and a second electrode layer may be formed on the first QD layer.

According to another aspect of the invention, there is provided a QD device including: a substrate structure; and a first QD layer that is formed on the substrate structure, which has a surface roughness equal to or less than about 5 nm, and has a thickness equal to or greater than about 50 nm.

### BRIEF DESCRIPTION OF THE DRAWINGS

The above and/or other aspects will become apparent and more readily appreciated from the following description of embodiments, taken in conjunction with the accompanying drawings in which:
FIG. 1 is a flowchart illustrating a method of manufacturing a QD device, according to one embodiment;
FIGS. 2A and 2B are cross-sectional views illustrating a QD device and a method of manufacturing the same, according to an embodiment;
FIG. 3 is a graph illustrating a method of adjusting a thickness of a QD layer in a method of manufacturing a QD device, according to an embodiment;
FIG. 4 is a graph illustrating that the same EL spectrum may be achieved when organic QDs and inorganic QDs are used, by using the method of manufacturing the QD device;
FIGS. 5A through 5C are cross-sectional views illustrating a QD device and a method of manufacturing the same, according to another embodiment;
FIGS. 6A through 6D are cross-sectional views illustrating a QD device and a method of manufacturing the same, according to another embodiment;
FIGS. 7A through 7C are cross-sectional views illustrating a QD device and a method of manufacturing the same, according to another embodiment;
FIG. 8 is a conceptual view illustrating a method of measuring the electron mobility of a QD device, according to an embodiment; and
FIG. 9 is a graph illustrating photocurrent for explaining a method of measuring a time taken for electrons to pass through a QD layer, in the method of FIG. 8, according to an embodiment.

### DETAILED DESCRIPTION OF THE EMBODIMENTS

As used herein, the term "and/or" includes any and all combinations of one or more of the associated listed items.

As used herein, the term "naturally evaporating," or variations thereof (e.g., "natural evaporation," "naturally evaporated," and the like), means evaporation without agitating the solution being evaporated enough to prevent, inhibit, disrupt, or undo the gathering of QDs on the surface of the solution being evaporated. As an example, naturally evaporating a solvent or solvent mixture containing a plurality of QDs may occur at standard pressure and temperature by permitting such a solution to be exposed, unagitated, to such an environment. Alternatively, decreased pressure or increased temperature may be used to perform natural evaporation, so long as the gathering of the QDs on the surface of the evaporating solution is not interrupted. These options are presented as examples only, and should not be understood to limit the meaning of the term "naturally evaporating" or variations thereof. However, a person having ordinary skill in the art will understand that spin coating is not a method by which a solution undergoes natural evaporation.

The accompanying drawings will now be described more fully. The drawings illustrate exemplary embodiments. In the drawings, the same elements are denoted by the same reference numerals, and sizes of elements may not be to scale, for the purposes of clarity and convenience of explanation.

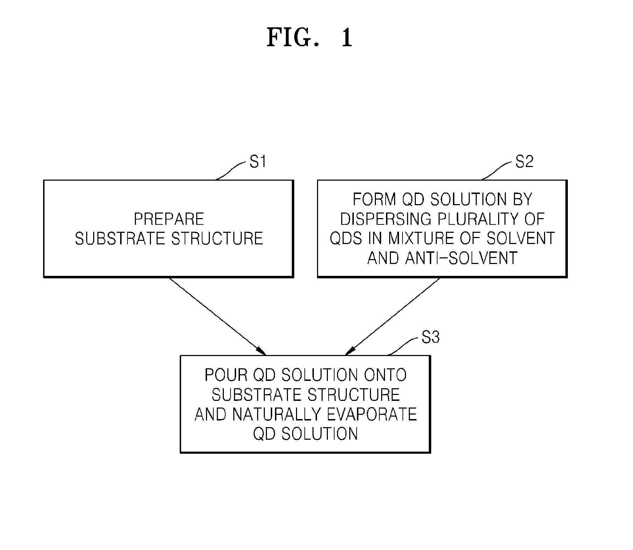

FIG. 1 is a flowchart illustrating a method of manufacturing a QD device, according to an embodiment.

In the method, in order to form a QD solution in which a plurality of QDs is dispersed, a mixture of a solvent and an anti-solvent is used. Since the solubility of the QDs is reduced as a result of mixing the solvent and the anti-solvent, QDs are precipitated and the QDs may be self-assembled. Thus, the thicknesses of the QDs may be easily adjusted.

In operation S1, a suitable substrate structure is prepared. The structure of the substrate is not particularly limited, and may be, for example, an electrode structure or a light-emitting structure. A specific example will be explained below.

In operation S2, a QD solution is formed by dispersing a plurality of QDs in a mixture of a solvent and an anti-solvent. Although the solvent and the anti-solvent are mixed with each other, they have different effects on the dispersal of the QDs.

The QDs may include any nanocrystals selected from the group consisting of Si-based nanocrystals, group II-VI compound semiconductor nanocrystals, group III-V compound semiconductor nanocrystals, group IV-VI compound semiconductor nanocrystals, and combinations thereof. The group II-VI compound semiconductor nanocrystals may be, for example, any one selected from the group consisting of CdS, CdSe, CdTe, ZnS, ZnSe, ZnTe, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HggZnTe, CdZnSeS, CdZnSeTe, CdZnSTe, CdHgSeS, CdHgSeTe, CdHgSTe, HgZnSeS, HgZnSeTe, and HgZnSTe. The group III-V compound semiconductor nanocrystals may be, for example, any one selected from the group consisting of GaN, GaP, GaAs, AlN, AlP, AlAs, InN, InP, InAs, GaNP, GaNAs, GaPAs, AlNP, AlNAs, AlPAs, InNP, InNAs, InPAs, GaAlNP, GaAlNAs, GaAlPAs, GaInNP, GaInNAs, GaInPAs, InAlNP, InAlNAs, and InAlPAs. The group IV-VI compound semiconductor nanocrystals may be, for example, SbTe.

The energy level of a QD layer varies according to the materials and sizes of the QDs. That is, the materials and the sizes of the QDs may be determined based on the wavelength of light that is emitted.

In general, the surfaces of QDs are surrounded by organic ligands or inorganic ligands. Based on the types of ligands that surround the QDs, the QDs may be referred to as organic QDs or inorganic QDs. A solvent in which the ligands are soluble is referred to a solvent, and a solvent in which ligands are insoluble is referred to as an anti-solvent.

The QDs dispersed in the mixture of the solvent and the anti-solvent may be organic QDs or inorganic QDs. It is known that when a QD layer is formed by using inorganic QDs, since a solubility is generally low, it is difficult to adjust a thickness of the QD layer. However, since the present embodiment actively uses the phenomenon that the solubility of QDs is reduced by mixing a solvent and an anti-solvent, the present embodiment is not affected by types of the QDs. That is, even when inorganic QDs are used, a desired thickness may be achieved.

Inorganic ligands may include, for example, metal chalcogenide (MCC)-based compounds, and examples of the MCC-based compounds include Sn₂S₆⁴⁻, Sn₂Se₆⁴⁻, In₂Se₄²⁻ Ge₂S₆⁴⁻ Ga₂Se₃, ZnTe, Sb₂S₃, Sb₂Se₃⁻, Sb₂Te₃, and In₂Te₃.

The solvent in which inorganic ligands are soluble may be any one of dimethyl sulfoxide (DMSO), water, formamide, and ethanolamine, or mixtures thereof; and the anti-solvent may be any one of dimethylformamide (DMF), ethylene glycol, acetonitrile, and glycerin, or mixtures thereof.

The solvent in which organic ligands are soluble may be an organic solvent, and the organic solvent may include any one of cyclohexane, chloroform, toluene, p-xylene, chlorobenzene, and dichlorobenzene, or mixtures thereof. The anti-solvent may be tetrahydrofuran (THF).

In operation S3, the QD solution is applied onto the substrate structure, and naturally evaporates. The QD solution may be applied onto the substrate structure using well-known methods including, for example, pouring the QD solution onto the substrate structure.

Specific examples using the method will be explained in detail below.

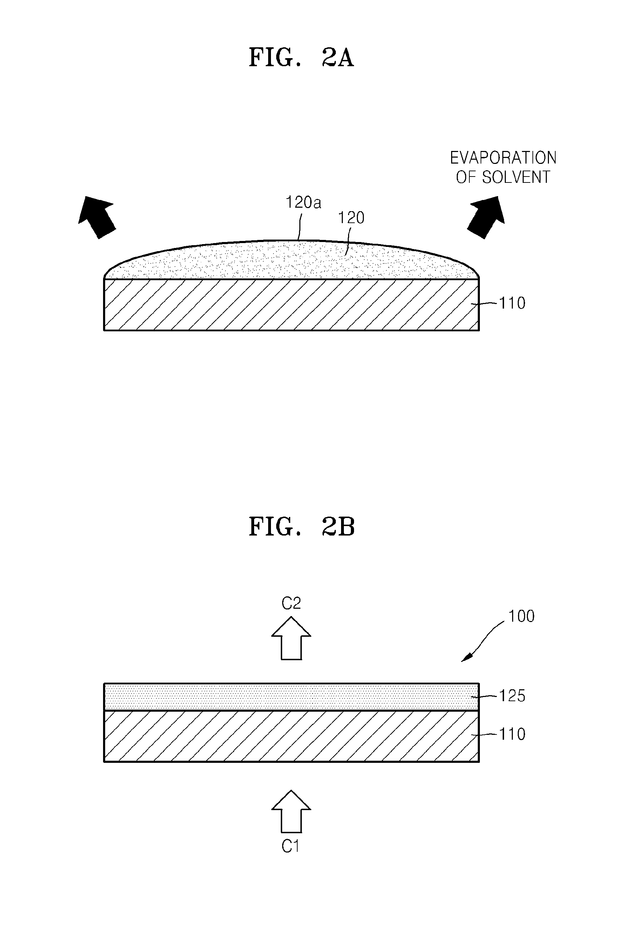

FIGS. 2A and 2B are cross-sectional views illustrating a QD device 100 and a method of manufacturing the same, according to an embodiment.

Referring to FIG. 2A, a QD solution 120 is poured onto a transparent substrate 110. The QD solution 120 is formed by dispersing a plurality of QDs in a mixture of a solvent and an anti-solvent. When the solubility of the QDs is reduced due to the anti-solvent, the QDs are precipitated. That is, they are gathered on a surface 120a of the QD solution 120. Next, as time passes, the mixture of the solvent and the anti-solvent naturally evaporates, and the QD device 100 in which a QD layer 125 is formed on the transparent substrate 110 is manufactured, as shown in FIG. 2B.

The QD device 100 may be applied to a color converting device that converts the color C1 of incident light into another color C2.

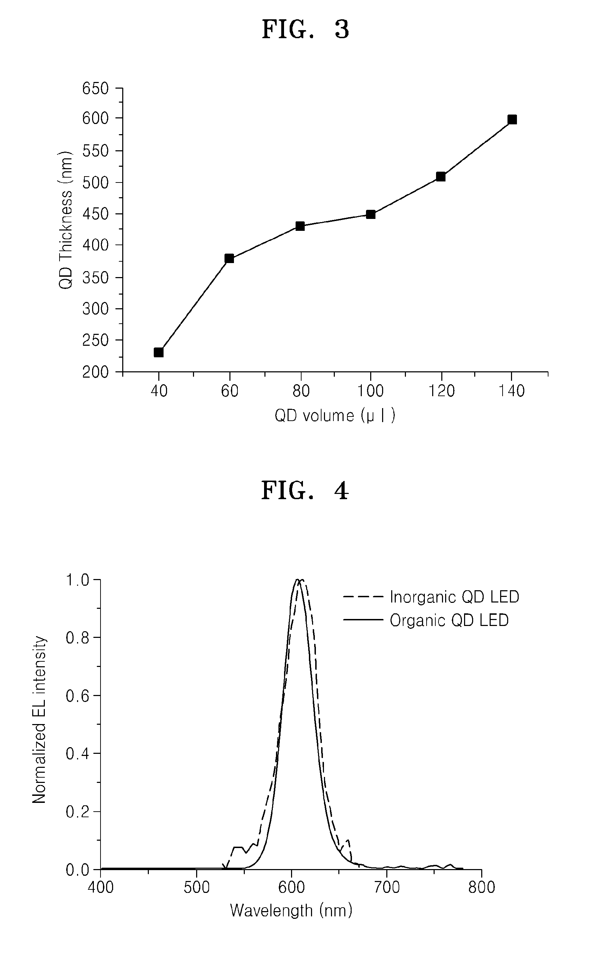

FIG. 3 is a graph illustrating a method of adjusting a thickness of a QD layer in a method of manufacturing a QD device, according to an embodiment.

When the QD layer is formed by the natural evaporation of a mixture of a solvent and anti-solvent, many QDs may be prevented from being discarded, as may occur during a spin coating process or the like, and thus a thickness of the QD layer is determined according to a volume of a QD solution used during the manufacture.

In the graph in FIG. 3, the horizontal axis represents a volume of the QD solution poured onto a surface of a substrate having an area of 25 mm x 25 mm, and the vertical axis represents a thickness of the QD layer formed from the QD solution. Since the thickness of the QD layer is proportional to the volume of the QD solution, this shows that it is easy to form a QD layer having a desired thickness.

Also, the inventors confirmed through experiments that when the QD layer is formed using the above-described method of manufacturing a QD device, the surface roughness of the QD layer is very low. The inventors confirmed using an optical microscope that while the root mean square (RMS) surface roughness of a QD layer manufactured using a general drop casting method is about 175 nm, the RMS surface roughness of the QD layer manufactured by using the method of the present embodiment is about 1.5 nm.

That is, according to the method of the present embodiment, a QD layer may be formed to a predetermined thickness, preferably a thickness equal to or greater than 50 nm, more preferably a thickness equal to or greater than 100 nm, and the QD device may be formed to have an RMS surface roughness equal to or less than about 10 nm, for example, equal to or less than about 5 nm.

Also, even when inorganic QDs are used in the method of the present embodiment, a QD layer may be formed to a predetermined thickness, for example, a thickness equal to or greater than about 50 nm, or about 100 nm.

The QD layer may have a thickness equal to or greater than 200 nm, 250 nm, 300 nm, 350 nm, 400 nm, 450 nm, 500 nm, 550 nm or 600 nm. The QD layer may have an RMS surface roughness equal to or less than 10 nm, 8 nm, 5 nm, 3 nm, 2 nm or 1.5 nm. FIG. 4 is a graph illustrating that the same electroluminescence (EL) spectrum may be achieved when organic QDs and inorganic QDs are used in the method of manufacturing a QD device according to the present embodiment.

It is known that when a QD device, for example, a QD light-emitting device, is formed using inorganic QDs, it has higher stability and reliability than a QD device formed using organic QDs because its operating voltage is lower and there is no burning phenomenon. However, it is also known that when a QD layer is formed using inorganic QDs, it is difficult to achieve a desired thickness because the solubility of the inorganic QDs is low. In the present embodiment, however, using the phenomenon that the solubility of QDs is reduced by mixing a solvent and an anti-solvent, it is easy to achieve a desired thickness both when organic QDs are used and when inorganic QDs are used.

As shown in FIG. 4, the same EL spectrum is obtained from a light-emitting device using organic QDs as a light-emitting device using inorganic QDs.

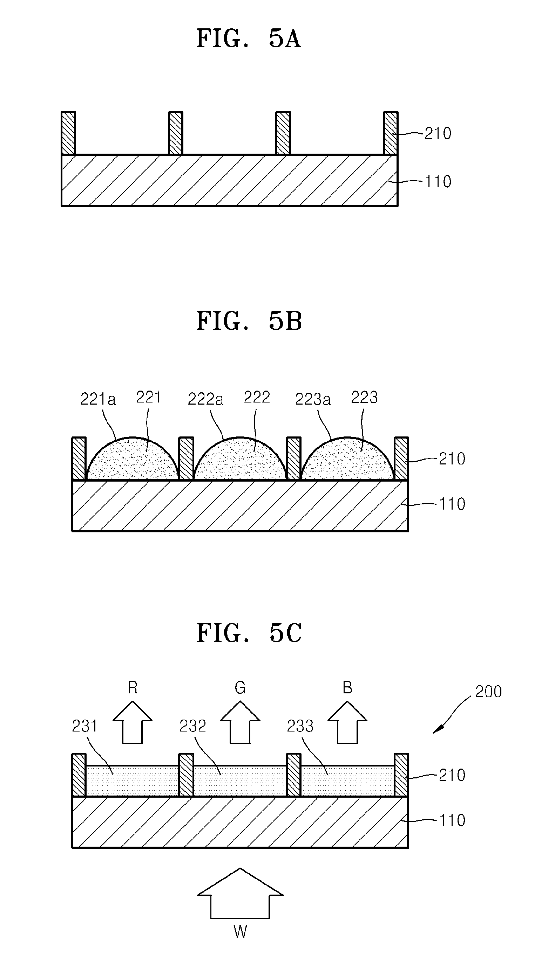

FIGS. 5A through 5C are cross-sectional views illustrating a QD device 200 and a method of manufacturing the same, according to another embodiment.

Referring to FIG. 5A, a substrate structure includes a transparent substrate 110, and transparent barriers 210 that are formed on the transparent substrate 110 to divide a region on the transparent substrate 110 into a plurality of regions.

Referring to FIG. 5B, different QD solutions, that is, a first QD solution 221, a second QD solution 222, and a third QD solution 223, are applied, or poured, onto the plurality of regions, respectively.

The first QD solution 221, the second QD solution 222, and the third QD solution 223 include different QDs having different energy levels such that different light-emitting wavelength bands are provided by adjusting the sizes or materials of the QDs.

The plurality of QDs included in the first QD solution 221, the second QD solution 222, and the third QD solution 223 are self-aligned on surfaces 221a, 222a, and 223a, and when a solvent evaporates, the QD device 200 in which a first QD layer 231, a second QD layer 232, and a third QD layer 233 are horizontally arranged is manufactured on the transparent substrate 110, as shown in FIG. 5C.

The QD device 200 may be applied to a color filter. To this end, transparent barriers 210 may be formed to correspond to display cells, and the first QD layer 231, the second QD layer 232, and the third QD layer 233 may be configured to respectively transmit therethrough red light R, green light G, and blue light B from the white light W incident thereon.

Since the first QD layer 231, the second QD layer 232, and the third QD layer 233 may be formed to great thicknesses, ranging from hundreds of nanometers to several micrometers, using the above-described method, color formation may be easier. When the QD device 200 is applied to a color filter, each of the first QD layer 231, the second QD layer 232, and the third QD layer 233 may be formed to have thicknesses equal to or greater than about 200 nm. For example, they may have thicknesses of about 500 nm.

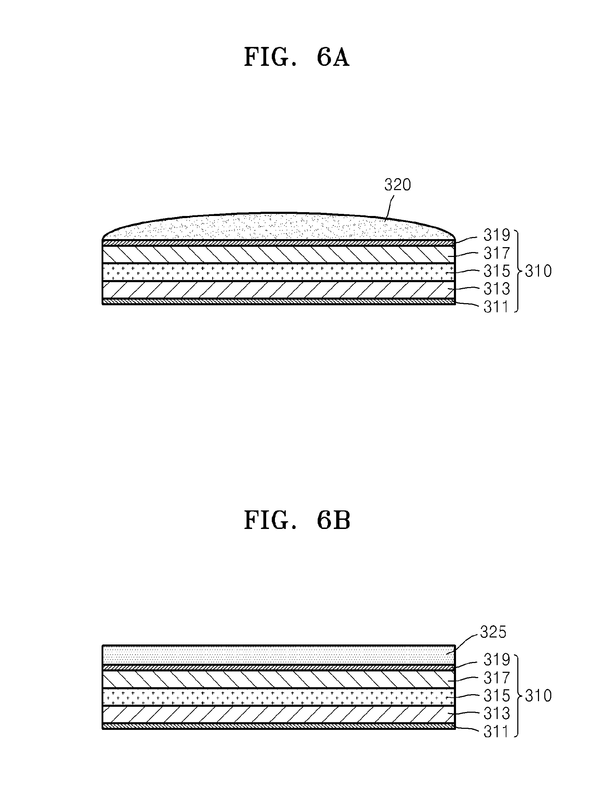

FIGS. 6A through 6D are cross-sectional views illustrating a QD device 300 and a method of manufacturing the same, according to another embodiment.

Referring to FIG. 6A, a substrate structure includes a light-emitting structure 310 that emits light having a predetermined wavelength. The light-emitting structure 310 may include, for example, an active layer 315, and a first electrode layer 311 and a second electrode layer 319 that apply voltages such that electrons and holes combine in the active layer 315. The first electrode layer 311 may act as a cathode, and the second electrode layer 319 may act as an anode. An electron transport layer 313 may be disposed between the first electrode layer 311 and the active layer 315, and a hole transport layer 317 may be disposed between the second electrode layer 319 and the active layer 315.

The active layer 315 may be formed of a material that emits blue light. The active layer 315 may be formed of various types of compound semiconductors or organic light-emitting layers. The specific materials of the hole transport layer 317 and the electron transport layer 313 are determined according to a material of the active layer 315.

A first QD solution 320 formed on the second electrode layer 319 may include QDs that emit light having a wavelength different from that of the light emitted by the light-emitting structure 310. For example, the first QD solution 320 may include QDs that absorb light emitted by the light-emitting structure 310 and emit light having a wavelength longer than that of the light emitted by the light-emitting structure 310. As the solution naturally evaporates, a first QD layer 325 is formed, as shown in FIG. 6B.

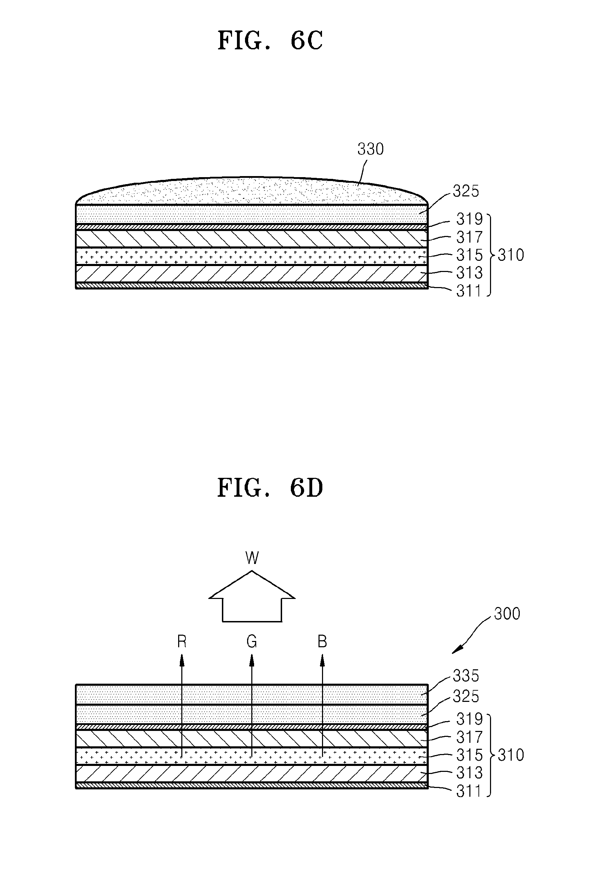

Next, as shown in FIG. 6C, a second QD solution 330 is formed on the first QD layer 325. The second QD solution 330 may include QDs that emit light having a wavelength different from that of light emitted by the light-emitting structure 310, and have materials or sizes different from those of the QDs included in the first QD solution 320. As the second QD solution 330 evaporates, a second QD layer 335 is formed as shown in FIG. 6D.

The QD device 300 of FIGS. 6A through 6D may be applied to a device that generally emits white light W by converting part of blue light B emitted by the light-emitting structure 300 into green light G and red light R.

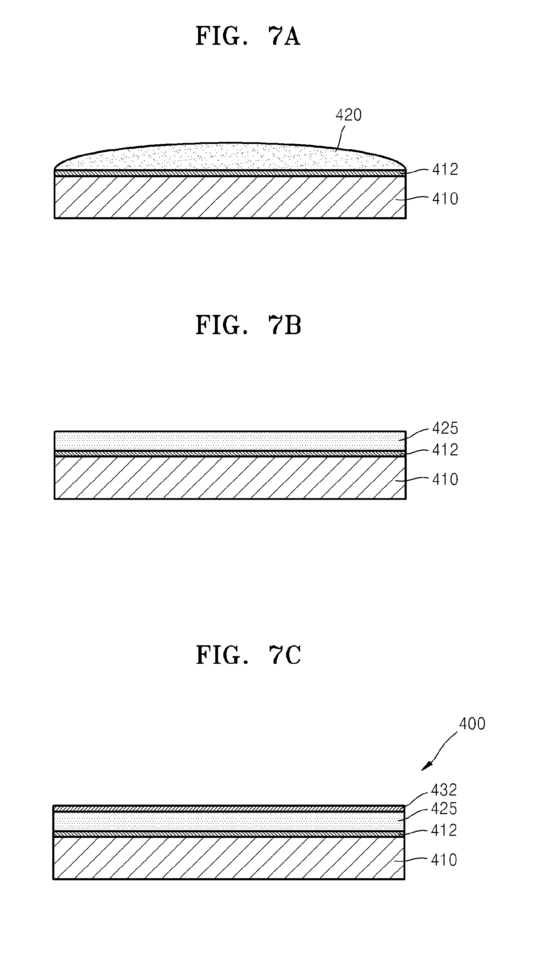

FIGS. 7A through 7C are cross-sectional views illustrating a QD device 400 and a method of manufacturing the same, according to another embodiment.

Referring to FIG. 7A, a first electrode layer 412 is formed on a substrate 410, and a QD solution 420 is formed on the first electrode layer 412. When the substrate 410 is a conductive substrate, the first electrode layer 412 may be omitted.

As the QD solution 420 evaporates, a QD layer 425 is formed, as shown in FIG. 7B.

Next, as shown in FIG. 7C, a second electrode layer 432 is formed on the QD layer 425, thereby manufacturing the QD device 400.

The QD device 400 may be applied to a QD light-emitting device in which the QD layer 425 acts as an active layer, that is, a light-emitting layer. Also, based on the desired light-emitting wavelength band, the materials and sizes of a plurality of QDs constituting the QD layer 425 may be determined. Also, an electron transport layer and a hole transport layer may be further disposed on the QD layer 425.

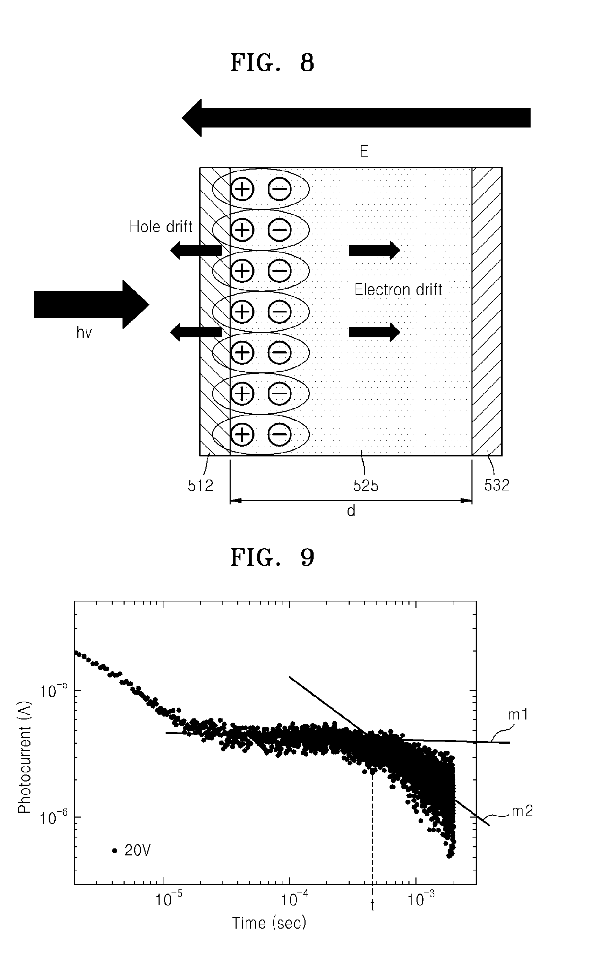

FIG. 8 is a conceptual view illustrating a method of measuring the electron mobility of a QD device, according to an embodiment. FIG. 9 is a graph illustrating photocurrent used herein to explain a method of measuring the time taken for electrons to pass through a QD layer, in the method of FIG. 8, according to an embodiment.

The method of measuring the electron mobility of the QD device of FIG. 8 uses a time of flight (TOF) method that measures the time taken for electrons to travel a given distance. In order to use the TOF method, a sufficient distance which electrons are to travel, that is, a sufficient thickness of a QD layer, should be secured. Accordingly, in order to form a thick QD layer, the above-described method of manufacturing a QD device may be used.

Referring to FIG. 8, a QD device including a first electrode 512, a QD layer 525, and a second electrode layer 532 is prepared. The QD device may be manufactured according to the above-described method, and the QD layer 525 is formed to a thickness equal to or greater than about 0.5 µm, for example, about 1 µm, in order to measure the TOF.

Next, light is irradiated to the QD device from the first electrode layer 512 toward the second electrode layer 532, and the time taken for electrons excited by the light to pass through the QD layer 525, that is, the time taken for the electrons to travel a distance d, is measured.

The light emitted to the QD device may be laser light having energy of hv. Here, h is Planck's constant, and v is the oscillation frequency of the light. The energy of the light may be greater than the work function of the material of the first electrode layer 512, and an electric field E may be formed in the QD layer 525 in a direction from the second electrode layer 532 toward the first electrode layer 512 such that the electrons move from the first electrode layer 512 toward the second electrode layer 532.

The time taken for the electrons to travel may be measured using the graph of FIG. 9. The time t corresponding to an intersection between the two gradients m1 and m2 in the graph of FIG. 9 is the TOF of the electrons.

The electron mobility may be obtained from the TOF t of the electrons passing through a thickness of the QD layer 525 which corresponds to the distance d. The electron mobility measured using the method of FIG. 8 becomes more accurate as the thickness of the QD layer increases.

The method of measuring the electron mobility of FIG. 8, which utilizes the technology of manufacturing a QD layer to a great thickness, may be effectively used to analyze the performance of a QD layer.

As described above, according to the method of manufacturing a QD device of the one or more embodiments described herein, QDs may be self-assembled, costs may be reduced because there is no QD loss during manufacture, and quantum devices having a large area may be manufactured.

Also, the thickness of a QD layer may be easily adjusted, and a thick film having a very low surface roughness may be formed.

The electron mobility of a QD device manufactured by using the manufacturing method may be measured by using a TOF method, and more accurate performance analysis may be performed.

Also, because a QD device manufactured by using the manufacturing method has no limitation as to the types of QDs that may be used, has desirable thickness, and has good surface roughness characteristics, the QD device may be applied to various devices, including, for example, light-emitting devices and color filters.

While various embodiments have been particularly shown and described, they are provided for the purposes of illustration, and it will be understood by those of ordinary skill in the art that various modifications and equivalent other embodiments can be made from the present disclosure.

## Claims

1. A method of forming a layer of quantum dots (QDs) on a substrate, the method comprising:
forming a first QD solution by dispersing a plurality of first QDs in a mixture of a solvent and an anti-solvent; and
forming a first QD layer by applying the QD solution onto the substrate and naturally evaporating the first QD solution applied onto the substrate.

2. The method of claim 1, the method further comprising:
forming a second QD solution by dispersing a plurality of second QDs in a mixture of a solvent and an anti-solvent, the plurality of second QDs having sizes or materials different from sizes or materials of the plurality of first QDs; and
forming a second QD layer on the first QD layer by applying the second QD solution onto the first QD layer and naturally evaporating the second QD solution applied onto the first QD layer.

3. The method of claim 1, the method further comprising:
forming a second QD solution by dispersing a in a mixture of a solvent and an anti-solvent, the plurality of second QDs having sizes or materials different from sizes or materials of the plurality of first QDs; and
forming a second QD layer on the first QD layer by applying the second QD solution onto a portion of the substrate where the first QD layer is not formed and naturally evaporating the second QD solution applied onto the portion of the substrate.

4. The method of any of claims 1-3, wherein at least one of the first QD layer and the second QD layer has a root mean square surface roughness of equal to or less than 10 nm.

5. A method of manufacturing a quantum dot (QD) device, the method comprising:
forming at least one QD layer on a substrate of a substrate structure by a method according to any of claims 1-4.

6. The method of claim 5, wherein the plurality of first QDs comprise:
inorganic QDs on surfaces of which inorganic ligands are formed; or
organic QDs on surfaces of which organic ligands are formed..

7. The method of any of claims 1-6, wherein the substrate is a transparent substrate, the method further comprising forming transparent barriers on the transparent substrate to divide a region on the transparent substrate into a plurality of regions.

8. The method of any of claims 5-7, wherein the substrate structure further comprises a light-emitting structure that emits light having a predetermined wavelength, wherein the forming of the first QD solution comprises forming the first QD solution by using a plurality of QDs that absorb light emitted by the light-emitting structure and emit light having a wavelength longer than that of the light emitted by the light-emitting structure.

9. The method of any of claims 4-8, wherein the substrate structure further comprises a first electrode layer formed on the substrate, the method further comprising forming a second electrode layer on the first QD layer.

10. A method of measuring an electron mobility of a quantum dot (QD) device manufactured in accordance with claim 9, the method comprising:
irradiating light to the QD layer in a direction from the first electrode layer toward the second electrode layer; and
measuring a time taken for electrons excited by the light to pass through the QD layer.

11. A quantum dot (QD) device comprising:
a substrate structure; and
a first QD layer that is formed on the substrate structure, said first QD layer having a root mean square surface roughness equal to or less than 10 nm, and a thickness equal to or greater than 50 nm.

12. The QD device of claim 11, wherein the first QD layer comprises a plurality of first inorganic QDs.

13. The QD device of claim 11 or 12, wherein the substrate structure comprises a transparent substrate, said QD device optionally further comprising transparent barriers that are formed on the transparent substrate and divide a region on the transparent substrate into plurality of regions.

14. The QD device of claim 28, further comprising a second QD layer that is formed on the first QD layer or on a portion of the transparent substrate where the first QD layer is not formed, said second QD layer hving a thickness equal to or greater than about 50 nm, wherein the second QD layer comprises a plurality of second inorganic QDs having sizes or materials different from sizes or materials of the plurality of first QD layer.

15. The QD device of any of claims 11-14, wherein the substrate structure comprises a light-emitting structure that emits light having a predetermined wavelength, and the plurality of inorganic first QDs optionally are arranged to absorb light emitted by the light-emitting structure and emit light having a wavelength longer than that of the light emitted by the light-emitting structure.

16. The QD device of any of claims 11-15, wherein the substrate structure comprises a substrate and a first electrode that is formed on the substrate, and a second electrode layer that is formed on the first QD layer.
